# FASCICULE DE BREVET EUROPEEN

(11) **EP 1 922 230 B1**
(45) Date de publication et mention de la délivrance du brevet: **18.05.2011**
(21) Numéro de dépôt: 06794390.2
(22) Date de dépôt: 01.09.2006
(51) Int. Cl.: B60R 16/02, B60Q 1/14, H05K 1/14, B60L 1/00

(54) **ENSEMBLE DE COMMANDE, NOTAMMENT POUR HAUT DE COLONNE DE DIRECTION DE VEHICULE AUTOMOBILE**
STEUERANORDNUNG, INSBESONDERE FÜR DEN OBERTEIL EINER KRAFTFAHRZEUGLENKSÄULE
CONTROL ASSEMBLY, IN PARTICULAR FOR MOTOR VEHICLE STEERING COLUMN TOP PORTION

(30) Priorité: 09.09.2005 FR 0509205
(43) Date de publication de la demande: 21.05.2008
(73) Titulaire: SC2N, 94042 Creteil Cedex (FR)
(72) Inventeur: HALLET, Michel, F-74320 Clinchamps-sur-Orne (FR); BRIOIS, Yohann, F-14810 Merville Franceville (FR)
(74) Mandataire: Benoit, Monique
(86) Numéro de dépôt international: PCT/FR2006/002035
(87) Numéro de publication internationale: WO 2007/028887

(56) Documents cités:
- WO-A-2004/098950

## Description

La présente invention est relative à un ensemble de commande, notamment pour haut de colonne de direction de véhicule automobile.

On connaît largement dans la technique des ensembles de commande pour un haut de colonne de direction de véhicule automobile.

De tels ensembles regroupent dans un même système plusieurs modules de commutateurs électriques pour,par exemple, commander des phares, les essuie-glaces, des fonctions audio, des fonctions de téléphonie ou encore des régulateurs de vitesse.

On a constaté depuis de nombreuses années que les véhicules sont de plus en plus personnalisés au niveau de leur équipement d'où une nécessité de pouvoir adapter les modules de commutateurs autour du volant à l'équipement effectivement présent sur le véhicule.

Ainsi, la modularité d'un ensemble de commande est un facteur important pour pouvoir adapter facilement un ensemble de base avec plusieurs modules optionnels aux besoins exprimés du client et pour pouvoir proposer des ensembles de commandes à un prix de revient acceptable.

On connaît du document W02004/098950 un ensemble de commande pour haut de colonne, selon le préambule de la revendication 1, qui présente des modules pouvant se brancher sur une carte mère avec un microcontrôleur. Dans ce document, les modules de commutation présentent des connecteurs identiques de branchement à la carte mère et chaque module possède un code d'identification. Combiné à ce code d'identification, le changement de l'état de commutation d'un des commutateurs d'un module est interprété de façon à délivrer un signal de sortie à l'équipement devant être commandé.

Ainsi, une bonne modularité de cet ensemble de commande est garantie.

Toutefois, il ressort de ce document que toutes les sorties des modules de commandes doivent être branchées sur une entrée correspondante du microcontrôleur ce qui aura comme désavantage un nombre très élevé de pistes sur la carte mère et surtout un nombre élevé d'entrées pour le microcontrôleur, ce qui augmente le prix de revient de celui-ci de façon considérable.

Pour réduire le nombre d'entrées du microcontrôleur, le document précité propose d'ajouter dans le circuit électrique un multiplexeur. Toutefois, cette solution ne paraît pas satisfaisante étant donné qu'il faut prévoir un composant électronique de plus dans le circuit.

Par ailleurs, étant donné que pour chaque commutateur d'un module, il faut prévoir une entrée dédiée du microcontrôleur, des modifications ultérieures et évolutions futures nécessitent des modifications de la carte mère et de ses composants entraînant ainsi des coûts importants de développement.

La présente invention vise à proposer un système de commutation plus simple et moins onéreux que celui de l'état de la technique tout en présentant une modularité satisfaisante.

Selon un objectif secondaire, l'invention vise à proposer une solution permettant de réduire considérablement les coûts de développement pour des évolutions futures.

A cet effet, l'invention a pour objet un ensemble de commande, notamment pour haut de colonne de direction de véhicule automobile, comprenant
- plusieurs modules de commutation tels qu'un module de commande d'éclairage, un module de commande des essuie-glace, un module de commande de fonctions audio, un module de commande de régulation de vitesse, chaque module possédant un identifiant propre,
- un microcontrôleur logé sur une carte mère, pouvant être relié à chaque module de commutation et servant à interpréter un état de commutation en fonction de l'identifiant du module pour délivrer un signal de commande approprié,
- la carte mère possédant plusieurs emplacements de branchement possédant un nombre N identique de pistes prédéfinies de branchement et pouvant accueillir chacun le branchement d'un module de commutation, et

- chaque module possédant un nombre N identique de pistes prédéfinies de branchement à des pistes associées de la carte mère,
caractérisé en ce que les pistes équivalentes de sortie de chaque module de commutation sont interconnectées et raccordées ensemble sur la même entrée du microcontrôleur, et en ce qu'il comprend pour chaque emplacement des moyens d'activation de lecture d'un état de commutation d'un module branché à cet emplacement, ces moyens d'activations étant pilotés par le microcontrôleur.

D'autres caractéristiques et avantages de l'invention ressortiront de la description suivante, donnée à titre d'exemple, sans caractère limitatif, en regard des dessins annexés sur lesquels :
- la figure 1 montre une vue en perspective arrière d'un haut de colonne de direction pour véhicule automobile monté sur une colonne de direction équipé d'un volant
- la figure 2 montre un schéma synoptique de connexion d'un ensemble de commande selon l'invention
- la figure 3 montre un schéma synoptique de connexion d'une carte mère d'un ensemble de commande selon l'invention,
- la figure 4 montre un schéma synoptique de connexion d'un exemple d'un module de connexion appartenant à un ensemble de commande selon l'invention,
- la figure 5 montre un schéma synoptique de connexion d'un exemple d'un sous-module de connexion selon l'invention,
- la figure 6 présente le même schéma que la figure 3 avec des modifications pour illustrer le fonctionnement de l'invention,
- la figure 7 présente le même schéma que la figure 4 avec des modifications pour illustrer le fonctionnement de l'invention, et
- la figure 8 présente le même schéma que la figure 5 avec des modifications pour illustrer le fonctionnement de l'invention.

Un exemple de réalisation non limitatif de l'invention sera décrit par la suite en relation avec les figures annexées.

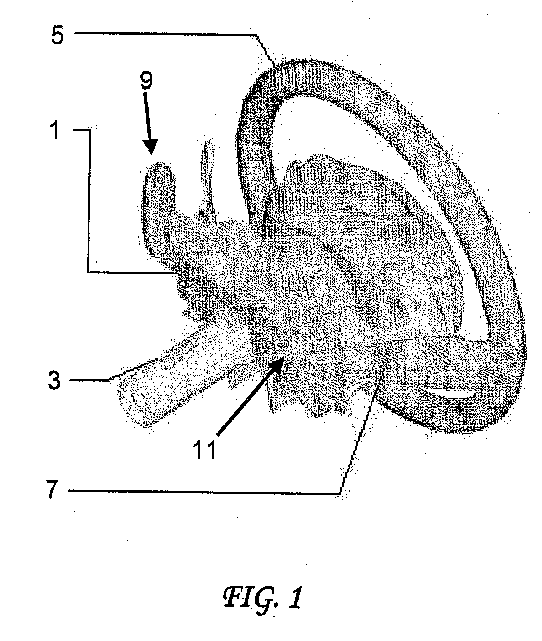

La figure 1 présente une vue en perspective depuis l'arrière d'un ensemble de commande 1 en particulier pour haut de colonne de direction de véhicule automobile.

Cet ensemble 1 est monté sur une colonne de direction 3 qui porte sur son extrémité arrière un volant 5.

A titre d'exemple, on voit sur la figure 1 que l'ensemble de commande présente sur des côtés opposés un levier de commande de l'éclairage 7 et un levier de commande des essuie-glace 9 monté sur un support central 11.

Comme cela sera décrit plus en détail ci-après, chaque levier est réalisé sous forme d'un module de commande, c'est-à-dire qu'il possède d'une part une mécatronique intrinsèque et propre qui traduit un mouvement d'un utilisateur en un changement d'état de commutation et d'autre part une connectique mécanique et électrique au support, en particulier à la carte mère de l'ensemble de commande, qui est standardisé et donc identique pour tous les modules pouvant être raccordés sur le support et à la carte mère.

Il en résulte que avantageusement, chaque module de commande peut être logé dans chaque emplacement du support 11 et être en même temps connecté électriquement à la carte mère.

Pour des agencements mécaniques d'ensemble de commande avec leurs leviers et autre commandes, par exemple pour traduire un mouvement en un changement de l'état de commutation, on pourra se référer utilement aux brevets suivants FR2782960, FR2833553, FR2800347.

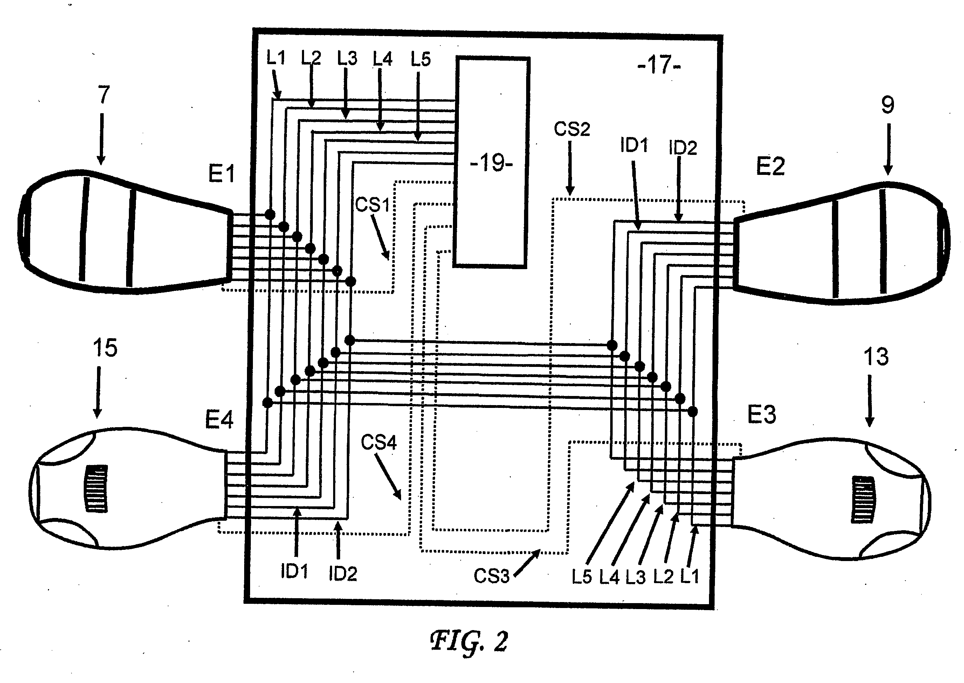

La figure 2 montre un schéma synoptique de connexion d'un ensemble de commande selon l'invention.

L'ensemble de commande 1 comprend plusieurs modules de commutation tels qu'un module de commande d'éclairage 7, un module de commande des essuie-glace 9, un module de commande de fonctions audio 13 et un module de commande de régulation de vitesse 15 qui sont prévus pour être branchés dans quatre emplacements E1, E2, E3 et E4 d'une carte mère 17, réalisé par exemple sous forme d'une carte PCB (« printed circuit board » ou carte à circuit imprimé en français), sur laquelle est logé un microcontrôleur 19.

Bien entendu, selon le besoin, on peut envisager encore plus de modules de commande aussi bien en ce qui concerne leur nombre pour un seul support que pour leurs fonctionnalités. Ainsi, il est envisageable de prévoir des modules de commandes supplémentaires par exemple pour des commandes de téléphone, des commandes pour un système de navigation ou même pour des commandes centralisés au niveau du volant pour la fermeture des vitres, du toit ouvrant etc..

De même, on peut envisager pour une même carte mère un nombre plus élevé d'emplacements pour brancher des modules de commutation sans déroger à l'esprit de la présente invention.

Le branchement des modules 7, 9, 13 et 15 aux emplacements E1, E2, E3 et E4 respectifs est réalisé à l'aide d'une connectique identique pour chaque module entre les parties mâle et femelle entre les modules et les pistes associés de la carte mère 17.

A cet effet, la carte mère 17 possède donc au niveau de chaque emplacement E1, E2, E3 et E4 un nombre N identique de pistes prédéfinies de branchement (N étant un nombre naturel prédéfini) et pouvant accueillir chacun le branchement d'un module de commutation.

Comme on le voit sur la figure 2, chaque module 7, 9, 13 et 15 comporte sept pistes L1, L2, L3, L4, L5, ID1, ID2 de sortie qui sont branchées sur des pistes associées de la carte mère 17.

Parmi les sept pistes, cinq pistes L1, L2, L3, L4, L5 servent à transmettre des états de commutation du module et deux pistes ID1, ID2 servent à transmettre un identifiant propre à chaque module au microcontrôleur 19.

Bien entendu on peut envisager selon le besoin un nombre supérieur ou inférieur de pistes à la fois pour transmettre l'état de commutation du module ou pour transmettre l'identifiant au microcontrôleur 19 si on respecte la règle que le nombre N de pistes est identique pour tous les emplacements E1 à E4 et pour tous les modules 7, 9, 13, 15.

Lors du fonctionnement, le microcontrôleur 19 sur la carte mère 17 servira à interpréter un état de commutation des pistes L1, L2, L3, L4, L5 en fonction de l'identifiant du module pour délivrer un signal de commande approprié, pour par exemple commander l'essuyage par intermittence des essuie-glace. Avantageusement, le microcontrôleur 19 est configuré de manière à délivrer ses signaux de sortie sur un réseau de communication, en particulier un bus de réseau du type LIN ou CAN.

On constate sur la figure 2 que, selon l'invention, les pistes équivalentes de sortie L1, L2, L3, L4, L5 et ID1, ID2 de chaque module de commutation sont interconnectées et raccordées ensemble sur la même entrée analogique du microcontrôleur 19 pour pouvoir utiliser la méthode peu coûteuse de la lecture des niveaux de tensions pour lire les états de commutation de chaque module.

Selon une variante non décrite, au moins une partie des entrées du microcontrôleur recevant une piste de sortie d'un module de commutation est une entrée analogique et les autres sont des entrées numériques.

Afin de permettre le branchement des modules de commutation 7, 9, 13 et 15 indépendamment du côté choisi de l'emplacement E1 à E4, la répartition des pistes équivalentes sur des côtés opposés de la carte mère 17 est inversée.

Ainsi vu sur la figure 2, les pistes L1 des modules 7 et 15 sont en haut suivi des pistes L2 à L5 et ID1 et ID2 vers le bas, alors que les pistes L1 des modules 9 et 13 sont en bas suivi des pistes L2 à L5 et ID1 et ID2 vers le haut.

Selon l'invention, l'ensemble de commande comprend en outre pour chaque emplacement des moyens d'activation de lecture d'un état de commutation d'un module branché à cet emplacement E1 à E4, ces moyens d'activations étant pilotés par le microcontrôleur via des pistes CS1, CS2, CS3 et CS4. Ces lignes de pilotage CS1, CS2, CS3 et CS4 sont raccordées à des sorties logiques du microcontrôleur 19. Selon le présent exemple, les lignes sont par défaut à l'état bas. Comme on va le voir par la suite, il est nécessaire de mettre une ligne CSx (x=1,2,3 ou 4) à l'état haut (environ 5V = tension d'alimentation) pour pouvoir lire l'état de commutation des commutateurs d'un des emplacements Ex (x=1,2,3 ou 4).

Bien entendu, le raccordement des lignes de pilotage respecte la même règle que les pistes Lx (x=1,2,3, 4 ou 5) ou IDx (x=1 ou 2), c'est-à-dire, qu'il y a un inversement afin de permettre le branchement des modules de commutation 7, 9, 13 et 15 indépendamment du côté choisi de l'emplacement E1 à E4.

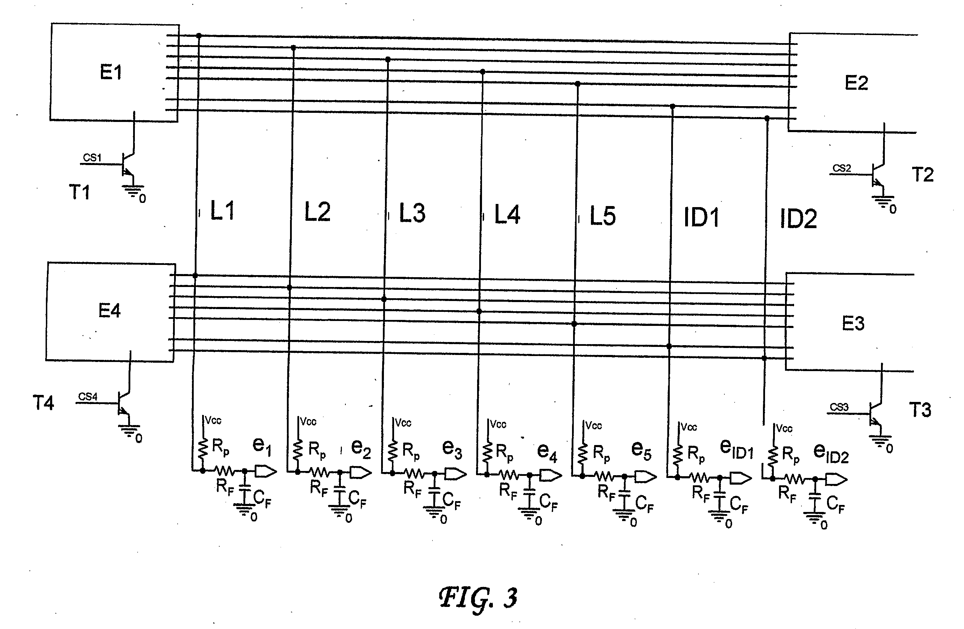

En passant maintenant à la figure 3 qui montre plus en détail le circuit électrique de la carte mère 17, on y distingue les quatre emplacements E1 à E4 de branchement des modules de commutation avec les pistes de lecture L1 à L5 de l'état de commutation et les pistes ID1 et ID2 pour transmettre l'identifiant d'un module au microcontrôleur 19.

On constate à nouveau que toutes les pistes équivalentes sont interconnectées et raccordées à une même entrée du microcontrôleur.

Ainsi, les lignes L1 des quatre emplacements E1 à E4 sont interconnectées et raccordées à l'entrée e₁ du microcontrôleur.

De façon analogue, chaque piste Lx (x=1,2,3, 4 ou 5) ou IDx (x=1 ou 2) est raccordée à l'entrée e_{Y} (Y=1,2,3, 4, 5, ID1 ou ID2).

Par ailleurs, on a prévu un filtre passe bas RC avec une résistance R_{F} et une capacité C_{F} classique devant chaque entrée e_{Y} (Y=1,2,3, 4, 5, ID1 ou ID2) du micro pour protéger l'entrée du microcontrôleur 19.

On relève également que chaque piste Lx (x=1,2,3,4 ou 5) ou IDx (x=1 ou 2) est raccordée à la tension d'alimentation V_{cc} et ainsi relevée via une résistance de « pull-up » Rₚ à la tension d'alimentation V_{cc}.

Selon l'invention, les moyens d'activation de lecture comprennent pour chaque emplacement E1 à E4 un moyen d'alimentation électrique du module de commutation branché de manière qu'en recevant un signal d'activation depuis une sortie numérique du microcontrôleur 19 via une ligne de pilotage correspondante CSx (x=1,2,3 ou 4), le module de commutation déterminé 7, 9, 13 ou 15 est mis sous tension de façon à permettre la lecture des états de commutation des commutateurs du module et qu'en absence de ce signal d'activation, les pistes de sortie du module de commutation possèdent un potentiel flottant.

Selon la réalisation spécifique décrite en relation avec les figures annexées et à titre d'exemple, le moyen d'alimentation électrique du module de commutation comprend donc d'une part pour chaque piste de sortie une connexion permanente, de préférence via la résistance d'adaptation Rₚ, à une tension d'alimentation (Vcc) et d'autre part, piloté par le microcontrôleur 19, un moyen de mise à la masse comprenant par exemple un transistor T₁, T₂, T₃, ou T₄ pour chaque emplacement Ex (x=1,2,3 ou4) respectif, branché en mode de commutation de manière qu'un signal numérique de sortie du microcontrôleur 19 permet d'amener le potentiel de masse au module de commutation pour permettre la lecture des états de commutation des commutateurs d'un module déterminé.

Plus en détail, si le microcontrôleur applique un signal logique « 0 » à la base d'un des transistors T1 à T4, celui-ci est bloqué et le potentiel de masse n'arrive pas à être amené dans le module de commutation, alors que si le microcontrôleur applique un signal logique « 1 » à la base d'un des transistors T1 à T4, celui-ci est rendu passant et le potentiel de masse est amené dans le module de commutation, permettant ainsi la lecture des états de commutation.

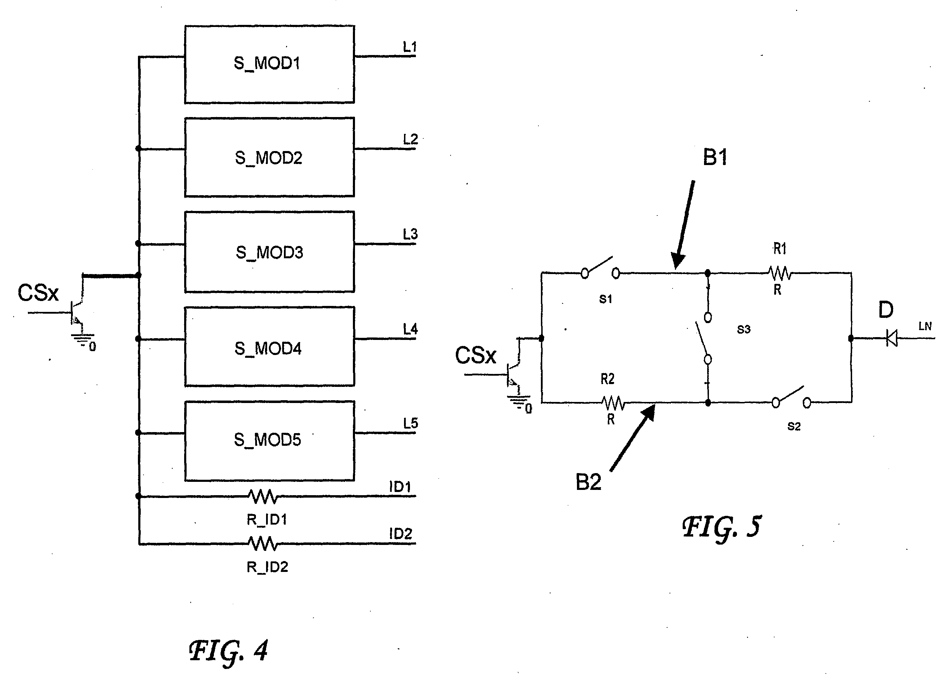

En se référant maintenant à la figure 4, on a représenté sur celle-ci un exemple d'un schéma de circuit électrique d'un module de commutation 7, 9, 13 ou 15.

Ce module de commutation se compose d'au moins un, dans le cas présent de cinq, sous-modules de commutation S_MODX (X= 1,2,3,4 ou 5) et d'un identifiant formé dans le présent exemple par deux résistances spécifiques disposés en parallèle R_ID1 et R_ID2. Les cinq sous-modules de commutation et les deux résistances spécifiques sont donc raccordés à une extrémité via une ligne commune aux moyens d'activation de lecture d'un état de commutation.

Bien entendu, dans une version simplifiée, il suffit de réaliser l'identifiant par au moins un composant électrique spécifique pour ce module de commutation, en particulier une résistance spécifique.

Comme on le voit sur la figure 4, les composants électriques spécifiques R_ID1 et R_ID2 sont branchés d'une part à une piste de sortie ID1, ID2 du module de commutation et d'autre part aux moyens de mise à la masse pilotés par le microcontrôleur 19.

En variante, on peut également prévoir une identification numérique avec un codage binaire pour chaque piste d'identification.

Sur cette figure, on comprend aussi le principe d'activation de lecture de chaque emplacement Ex (X= 1,2,3 ou 4).

En effet, étant donné que chaque piste Lx (x=1,2,3,4 ou 5) ou IDx (x=1 ou 2) est raccordée via Rₚ à la tension d'alimentation V_{cc}, on peut lire l'état de commutation du module dans son ensemble ainsi que son identifiant seulement si la ligne de pilotage CSx (x=1,2,3 ou 4) est mise par le microcontrôleur 19 au niveau bas, à la masse.

Bien entendu, dans le fonctionnement global de l'invention, les lignes CSx (x=1,2,3 ou 4) sont mises par le microcontrôleur 19 au niveau bas, à la masse un à un, à tour de rôle et exclusivement une ligne à la fois. En effet, le microcontrôleur 19 est configuré de manière à activer périodiquement au niveau de chaque emplacement la lecture des états de commutation.

Chaque sous-module S_MODX (X= 1,2,3,4 ou 5) comporte au moins un de préférence plusieurs commutateurs individuels pouvant prendre des états de commutation ouverts ou fermés en fonction des positions de commande appliquées par un utilisateur au sous-module.

On prévoit ainsi à titre d'indication non limitative de réaliser un sous-module sous la forme d'un bouton - pression, d'un interrupteur à bascule, d'une molette indexée, d'une bague rotative ou d'un levier de commande.

Un exemple d'un sous-module de commutation particulièrement avantageux est représenté sur la figure 5.

En effet, ce sous-module comporte un circuit électrique avec deux branches B₁ et B₂ en parallèles.

En partant depuis la ligne destinée à être mise à la masse par le ligne de pilotage CSX, la première branche B₁ présente en série un premier commutateur S1 et une première résistance R1 et la seconde branche B₂ présente en série une seconde résistance R2 et un second commutateur S2.

De plus, les deux branches B₁ et B₂ peuvent être reliées au milieu entre respectivement les premier commutateur S1 et première résistance R1 d'une part et les seconde résistance R2 et second commutateur S2 d'autre part, par un troisième commutateur S3 de manière à pouvoir obtenir cinq niveaux de tensions représentant cinq états différents de commutation de l'ensemble des premier, second et troisième commutateurs.

Cette solution a plusieurs avantages notables, car on obtient cinq niveaux de tensions avec une répartition égale optimisée réduisant ainsi des possibles erreurs de lecture. De plus, on peut réduire le nombre de résistances à deux au lieu de trois dans l'état de la technique.

Puis, les deux résistances R1 et R2 du sous-module S_MODX sont identiques de préférence égale à est choisie entre 2kΩ et 5kΩ, de préférence de l'ordre de 3,6kΩ.

Selon des mesures effectuées, les tensions obtenues avec cette configuration sont :

| Configuration des switchs | | | Tensions obtenues | | |
|---|---|---|---|---|---|
| S1 | S2 | S3 | U min | U nom | U max |
| O | O | O | 5.00 | 5.00 | 5.00 |
| O | F | O | 3.76 | 3.93 | 4.10 |
| O | O | F | 2.92 | 3.10 | 3.29 |
| F | O | F | 2.10 | 2.27 | 2.44 |
| F | F | F | 0.56 | 0.64 | 0.72 |

| | | | | | |
|---|---|---|---|---|---|
| O - interrupteur en question est ouvert F - interrupteur en question est fermé | | | | | |

Les tensions données dans le tableau Uₘᵢₙ (tension minimale constatée) Uₙₒₘ (tension nominale constatée) Uₘₐₓ (tension maximale constatée) sont des tensions en Volt avec une tension d'alimentation V_{cc} de 5V. Les tensions Uₘᵢₙ et Uₘₐₓ tiennent compte des tolérances des composants.

Pour minimiser les interférences entre les sous-modules, une diode D est placée dans le circuit dans la piste LN (N=1,2,3,4 ou 5).

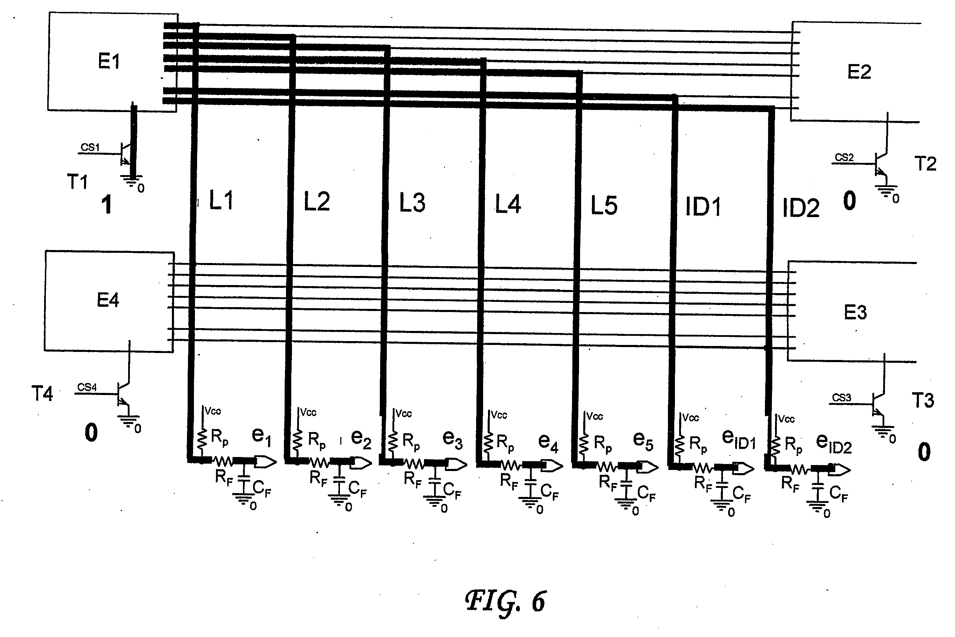

Par la suite, on décrira le fonctionnement de l'ensemble de commutation en détail en référence aux figures 6, 7 et 8.

Pour cela, on suppose que les quatre modules de commutation 7, 9, 13 et 15 sont respectivement branchés dans les emplacements E1 à E4 de la carte mère.

On suppose que le microcontrôleur doit procéder à la lecture des états de commutations du module 7, c'est-à-dire par exemple le levier de commande de l'éclairage, qui est banché dans l'emplacement E1, mais la lecture des états de commutation des autres modules se fait exactement de la même manière.

A cet effet, le microcontrôleur passe la ligne de pilotage CS1 en niveau haut, ce qui est représenté par le chiffre « 1 » en gras à côté du transistor T1. Ceci rend le transistor T1 passant, de sorte que le module de commutation 7 est maintenant relié d'une part à la masse et d'autre part , via les lignes L1 à L5 ainsi que ID1 et ID2 à la tension V_{cc}.

Par les chiffres « 0 » en gras à côté des transistors T2 à T4, on a indiqué que le microcontrôleur applique lors de la lecture des états de commutation du module 7 le niveau logique bas rendant ainsi ces transistors T2 à T4 bloquant. Ainsi, les autres modules 9, 13 et 15 n'interfèrent pas dans la lecture du module 7 indépendamment des actions qu'un utilisateur peut exercer sur les modules et en particulier sur les interrupteurs / commutateurs de ces modules.

Sur les figures 6 , 7 et 8, on a représenté en gras les lignes alimentées pour la lecture des états de commutation du module 7.

Et par conséquent, on voit que par le signal d'activation du microcontrôleur 19, on met l'emplacement E1 et le module de commutation 7 en état de lecture des lignes L1 à L5 ainsi ID1 et ID2.

On peut remarquer aussi un autre avantage de l'invention, car même si un emplacement est vide, par exemple parce que un module de commutation a été retiré, le fonctionnement de l'ensemble de commutation n'est nullement affecté. De plus, le microcontôleur peut reconnaître qu'un emplacement est vide étant donné que les lignes d'identification IDI et ID2 sont toutes les deux à un potentiel correspondant à la tension d'alimentation V_{cc}.

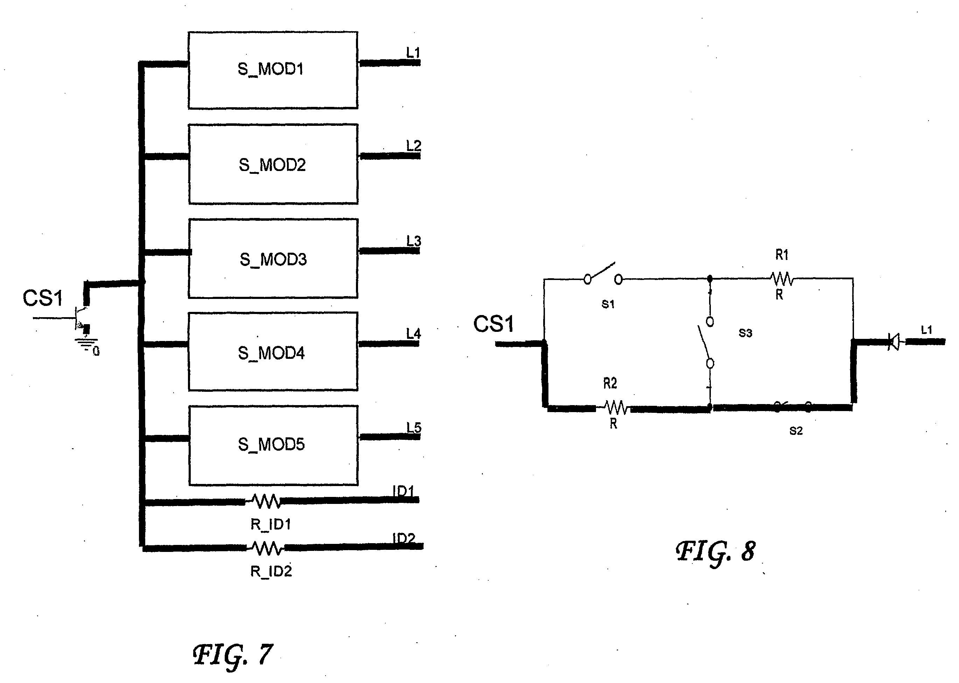

Si on passe maintenant à la figure 7 montrant le module de commutation 7, on observe aussi comment le signal de pilotage permet d'alimenter à la fois les sous-modules S_MODX (X= 1 à 5) et les résistances d'identification R_ID1 et R_ID2.

Puis, la figure 8 montre à titre d'exemple un des sous-modules S_MODX pour lequel les commutateurs S1 et S3 sont ouverts et le commutateur S2 est fermé, de sorte que l'on mesure la tension de 3,96V à l'entrée du microcontrôleur de la ligne L1.

On comprend donc que la présente invention se distingue par son aisance d'implantation, par un coût réduit et par une possibilité de modularité exemplaire.

## Revendications

1. Ensemble de commande, notamment pour haut de colonne de direction (1) de véhicule automobile, comprenant
• plusieurs modules de commutation (7 ; 9 ; 13 ; 15) tels qu'un module de commande d'éclairage, un module de commande des essuie-glace, un module de commande de fonctions audio, un module de commande de régulation de vitesse, chaque module possédant un identifiant propre,
• un microcontrôleur (19) logé sur une carte mère (17), pouvant être relié à chaque module de commutation (7 ; 9 ; 13 ; 15) et servant à interpréter un état de commutation en fonction de l'identifiant du module pour délivrer un signal de commande approprié,
• la carte mère (17) possédant plusieurs emplacements (E1, E2, E3, E4) de branchement possédant un nombre N identique de pistes prédéfinies (L1, L2, L3, L4, L5, ID1, ID2 ; CS1 ; CS2 ; CS3 ; CS4) de branchement et pouvant accueillir chacun le branchement d'un module de commutation (7 ; 9 ; 13 ; 15), et
• chaque module (7 ; 9 ; 13 ; 15) possédant un nombre N identique de pistes prédéfinies de branchement (L1, L2, L3, L4, L5, ID1, ID2; CS1 ; CS2 ; CS3 ; CS4) à des pistes associées de la carte mère (17),
**caractérisé en ce que** les pistes équivalentes de sortie (L1, L2, L3, L4, L5, ID1, ID2) de chaque module de commutation (7 ; 9 ; 13 ; 15) sont interconnectées et raccordées ensemble sur la même entrée du microcontrôleur (19), et **en ce qu'**il comprend pour chaque emplacement (E1, E2, E3, E4) des moyens d'activation de lecture d'un état de commutation d'un module branché à cet emplacement, ces moyens d'activations étant pilotés par le microcontrôleur (19).

2. Ensemble de commande selon la revendication 1, **caractérisé en ce que** chaque entrée (e₁, e₂, e₃, e₄, e₅, e_{ID1}, e_{ID2}) du microcontrôleur (19) recevant une piste de sortie (L1, L2, L3, L4, L5, ID1, ID2) d'un module de commutation est une entrée analogique.

3. Ensemble de commande selon la revendication 2, **caractérisé en ce que** les moyens d'activation de lecture comprennent pour chaque emplacement (E1, E2, E3, E4) un moyen d'alimentation électrique du module de commutation branché de manière qu'en recevant un signal d'activation d'une sortie prédéfinie du microcontrôleur (19), le module de commutation (7, 9, 13, 15) est mis sous tension de façon à permettre la lecture des états de commutation des commutateurs du module et qu'en absence de ce signal d'activation, les pistes de sortie du module de commutation possèdent un potentiel flottant.

4. Ensemble de commande selon la revendication 3, **caractérisé en ce que** le moyen d'alimentation électrique du module de commutation comprend d'une part pour chaque piste de sortie une connexion permanente, de préférence via une résistance d'adaptation (Rₚ), à une tension d'alimentation (Vcc) et d'autre part un moyen de mise à la masse (T1, T2, T3, T4) piloté par le microcontrôleur.

5. Ensemble de commande selon la revendication 4, **caractérisé en ce que** chaque moyen de mise à la masse comprend un transistor (T1, T2, T3, T4) branché en mode de commutation de manière q'un signal numérique de sortie du microcontrôleur (19) permet d'amener le potentiel de masse au module de commutation (7, 9, 13, 15) pour permettre la lecture des états de commutations des commutateurs des modules.

6. Ensemble de commutation selon l'une quelconque des revendications 1 à 5, **caractérisé en ce que** chaque module de commutation comprend au moins un identifiant (R_ID1, R_ID2) et un sous-module (S_MOD1, S_MOD2, S_MOD3, S_MOD4, S_MOD5) avec plusieurs commutateurs individuels (S1, S2, S3) pouvant prendre des états de commutation ouverts ou fermés en fonction des positions de commande appliquées par un utilisateur au sous-module.

7. Ensemble selon la revendication 6, **caractérisé en ce qu'**un sous-module est réalisé sous la forme d'un bouton - pression, d'un interrupteur à bascule, d'une molette indexée, d'une bague rotative ou d'un levier de commande.

8. Ensemble de commutation selon la revendication 6 ou 7, **caractérisé en ce que** l'identifiant est réalisé par au moins un composant électrique spécifique pour ce module de commutation, en particulier une résistance spécifique (R_ID1, R_ID2).

9. Ensemble de commutation selon la revendication 8 prise ensemble avec la revendication 4 ou 5, **caractérisé en ce que** le composant électrique spécifique (R_ID1, R_ID2) est branché d'une part à une piste de sortie du module de commutation (ID1 ; ID2) et d'autre part aux moyens de mise à la masse (T1 ; T2 ; T3 ; T4) pilotés par le microcontrôleur (19).

10. Ensemble de commutation selon l'une quelconque des revendications 6 à 9, **caractérisé en ce que** dans un module de commutation (7, 9, 13, 15), le au moins un sous-module (S_MOD1) et le au moins une piste d'identifiant comportant le composant spécifique (R_ID1, R_ID2) du module sont raccordées à une extrémité via une ligne commune aux moyens d'activation de lecture d'un état de commutation.

11. Ensemble de commutation selon l'une quelconque des revendications 6 à 10, **caractérisé en ce qu'**au moins un sous-module de commutation (S_MOD1) comporte un circuit électrique avec deux branches (B1, B2) en parallèle, dont la première branche (B1) présente en série un premier commutateur (S1) et une première résistance (R1) et dont la seconde branche (B2) présente en série une seconde résistance (R2) et un second commutateur (S2), les deux branches (B1, B2) pouvant être reliées au milieu entre respectivement les premier commutateur (S1) et première résistance (R1) d'une part et les seconde résistance (R2) et second commutateur (S2) d'autre part, par un troisième commutateur (S3) de manière à pouvoir obtenir cinq niveaux de tensions représentant cinq états différents de commutation de l'ensemble des premier, second et troisième commutateurs (S1, S2, S3).

12. Ensemble de commutation selon la revendication 11, **caractérisé en ce que** les première (R1) et seconde (R2) résistances sont identiques.

13. Ensemble de commutation selon la revendication 12, **caractérisé en ce que** la valeur des première et seconde résistances est choisie entre 2kΩ et 5kΩ, de préférence de l'ordre de 3,6kΩ.

14. Ensemble de commutation selon l'une quelconque des revendications 1 à 13, **caractérisé en ce que** le microcontrôleur (19) est configuré de manière à activer périodiquement au niveau de chaque emplacement la lecture des états de commutation.

15. Ensemble de commutation selon l'une quelconque des revendications 1 à 14, **caractérisé en ce que** le microcontrôleur (19) est configuré de manière à délivrer ses signaux de sortie sur un réseau de communication, en particulier un bus de réseau du type LIN ou CAN.

16. Ensemble de commutation selon l'une quelconque des revendications 1 à 15, **caractérisé ce que** la carte mère (17) possède des emplacements (E1, E2, E3, E4) de branchement sur des côtés opposés et en ce que la répartition des pistes équivalentes (L1, L2, L3, L4, L5, ID1, ID2) est inversée de manière à permettre le branchement des modules de commutation indépendamment du côté choisi de l'emplacement.

## Claims

1. Control assembly, in particular for the top part of an automobile vehicle steering column (1), comprising
• several switching modules (7; 9; 13; 15) such as a lighting control module, a windshield wiper control module, an audio function control module, a speed regulation control module, each module having its own identifier,
• a microcontroller (19) accommodated on a motherboard (17), capable of being connected to each switching module (7; 9; 13; 15) and used to interpret a switching state as a function of the identifier of the module in order to deliver an appropriate control signal,
• the motherboard (17) having several edge connectors (E1, E2, E3, E4) having an identical number N of predefined connecting tracks (L1, L2, L3, L4, L5, ID1, ID2; CS1; CS2; CS3; CS4) and each being capable of receiving the connection of a switching module (7; 9; 13; 15), and
• each module (7; 9; 13; 15) having an identical number N of predefined tracks (L1, L2, L3, L4, L5, ID1, ID2; CS1; CS2; CS3; CS4) for connecting to associated tracks on the motherboard (17),
**characterized in that** the equivalent output tracks (L1, L2, L3, L4, L5, ID1, ID2) of each switching module (7; 9; 13; 15) are interconnected and connected together on the same input of the microcontroller (19), and **in that** it comprises, for each edge connector, (E1, E2, E3, E4) means for activating the reading of a switching state of a module connected to this edge connector, these activation means being driven by the microcontroller (19).

2. Control assembly according to Claim 1, **characterized in that** each input (e₁, e₂, e₃, e₄, e₅, e_{ID1,} e_{ID2}) of the microcontroller (19) receiving an output track (L1, L2, L3, L4, L5, ID1, ID2) from a switching module is an analog input.

3. Control assembly according to Claim 2, **characterized in that** the read activation means comprise, for each edge connector (E1, E2, E3, E4), an electrical power supply means for the switching module connected in such a manner that, when it receives an activation signal from a predefined output of the microcontroller (19), the switching module (7, 9, 13, 15) is powered up so as to allow the switching states of the switches of the module to be read and such that, in the absence of this activation signal, the output tracks of the switching module are at a floating potential.

4. Control assembly according to Claim 3, **characterized in that** the electrical power supply means for the switching module comprises, on the one hand, for each output track a permanent connection, preferably via a matching resistor (Rₚ), to a power supply voltage (Vcc) and, on the other hand, a grounding means (T1, T2, T3, T4) driven by the microcontroller.

5. Control assembly according to Claim 4, **characterized in that** each grounding means comprises a transistor (T1, T2, T3, T4) connected in switching mode in such a manner that a digital output signal from the microcontroller (19) allows ground potential to be connected to the switching module (7, 9, 13, 15) in order to allow the switching states of the switches of the modules to be read.

6. Control assembly according to any one of Claims 1 to 5, **characterized in that** each switching module comprises at least one identifier (R_ID1, R_ID2) and one sub-module (S_MOD1, S_MOD2, S_MOD3, S_MOD9, S_MOD5) with several individual switches (S1, S2, S3) that can take open or closed switching states depending on the control positions applied by a user to the sub-module.

7. Assembly according to Claim 6, **characterized in that** a sub-module takes the form of a push-button, a toggle switch, an indexed thumb-wheel, a rotating knob or a control lever.

8. Switching assembly according to either of Claims 6 and 7, **characterized in that** the identifier is formed by at least one specific electrical component for this switching module, in particular a specific resistor (R_ID1, R_ID2).

9. Switching assembly according to Claim 8 taken together with either of Claims 4 and 5, **characterized in that** the specific electrical component (R_ID1, R_ID2) is connected, on the one hand, to an output track of the switching module (ID1; ID2) and, on the other hand, to the grounding means (T1; T2; T3; T4) driven by the microcontroller (19).

10. Switching assembly according to any one of Claims 6 to 9, **characterized in that**, in a switching module (7, 9, 13, 15), the at least one sub-module (S_MOD1) and the at least one identifier track comprising the specific component (R_ID1, R_ID2) of the module are connected at one end via a common line to the read activation means for a switching state.

11. Switching assembly according to any one of Claims 6 to 10, **characterized in that** at least one switching sub-module (S_MOD1) comprises an electrical circuit with two branches (B1, B2) in parallel, the first branch (B1) of which has a first switch (S1) and a first resistor (R1) in series and the second branch (B2) of which has a second resistor (R2) and a second switch (S2) in series, where the two branches (B1, B2) may be connected in the middle between, respectively, the first switch (S1) and the first resistor (R1), on the one hand, and the second resistor (R2) and second switch (S2), on the other hand, via a third switch (S3) in such a manner as to be able to obtain five voltage levels representing five different switching states of the set of the first, second and third switches (S1, S2, S3).

12. Switching assembly according to Claim 11, **characterized in that** the first (R1) and second (R2) resistors are identical.

13. Switching assembly according to Claim 12, **characterized in that** the value of the first and second resistors is chosen to be between 2kΩ and 5kΩ, preferably around 3.6 kΩ.

14. Switching assembly according to any one of Claims 1 to 13, **characterized in that** the microcontroller (19) is configured in such a manner as to periodically activate, at each edge connector, the reading of the switching states.

15. Switching assembly according to any one of Claims 1 to 14, **characterized in that** the microcontroller (19) is configured in such a manner as to deliver its output signals onto a communications network, in particular a network bus of the LIN or CAN type.

16. Switching assembly according to any one of Claims 1 to 15, **characterized in that** the motherboard (17) has edge connectors (E1, E2, E3, E4) on opposite sides and **in that** the distribution of the equivalent tracks (L1, L2, L3, L4, L5, ID1, ID2) is reversed in such a manner as to allow the switching modules to be connected irrespective of the side chosen for the edge connector.

## Patentansprüche

1. Steuereinheit, insbesondere für den oberen Bereich einer Kraftfahrzeug-Lenksäule (1), die enthält
• mehrere Schaltmodule (7; 9; 13; 15), wie ein Beleuchtungssteuermodul, ein Scheibenwischer-Steuermodul, ein Steuermodul von Audiofunktionen, ein Geschwindigkeitregelungsmodul, wobei jedes Modul eine eigene Kennung besitzt,
• einen auf einer Mutterplatine (17) angeordneten Mikrocontroller (19), der mit jedem Schaltmodul (7; 9; 13; 15) verbunden werden kann und dazu dient, einen Schaltzustand abhängig von der Kennung des Moduls zu interpretieren, um ein geeignetes Steuersignal zu liefern,
• wobei die Mutterplatine (17) mehrere Anschlussplätze (E1, E2, E3, E4) besitzt, die eine gleiche Anzahl N von vordefinierten Anschlusspfaden (L1, L2, L3, L4, L5, ID1, ID2; CS1; CS2; CS3; CS4) besitzen und je den Anschluss eines Schaltmoduls (7; 9; 13; 15) aufnehmen können, und
• jedes Modul (7; 9; 13; 15) eine gleiche Anzahl N von vordefinierten Anschlusspfaden (L1, L2, L3, L4, L5, ID1, ID2; CS1; CS2; CS3; CS4) an zugeordnete Pfade der Mutterplatine (17) besitzt,
**dadurch gekennzeichnet, dass** die äquivalenten Ausgangspfade (L1, L2, L3, L4, L5, ID1, ID2) jedes Schaltmoduls (7; 9; 13; 15) miteinander verbunden und zusammen an den gleichen Eingang des Mikrocontrollers (19) angeschlossen sind, und dass sie für jeden Platz (E1, E2, E3, E4) Aktivierungseinrichtungen des Ablesens eines Schaltzustands eines an diesen Platz angeschlossenen Moduls enthält, wobei diese Aktivierungseinrichtungen vom Mikrocontroller (19) gesteuert werden.

2. Steuereinheit nach Anspruch 1, **dadurch gekennzeichnet, dass** jeder Eingang (e₁, e₂, e₃, e₄, e₅, e_{ID1}, e_{ID2}) des Mikrocontrollers (19), der einen Ausgangspfad (L1, L2, L3, L4, L5, ID1, ID2) eines Schaltmoduls empfängt, ein analoger Eingang ist.

3. Steuereinheit nach Anspruch 2, **dadurch gekennzeichnet, dass** die Leseaktivierungseinrichtungen für jeden Platz (E1, E2, E3, E4) eine Einrichtung zur Stromversorgung des Schaltmoduls enthalten, die so angeschlossen ist, dass das Schaltmodul (7, 9, 13, 15), wenn es ein Aktivierungssignal von einem vordefinierten Ausgang des Mikrocontrollers (19) empfängt, eingeschaltet wird, um das Ablesen der Schaltzustände der Schalter des Moduls zu erlauben, und dass in Abwesenheit dieses Aktivierungssignals die Ausgangspfade des Schaltmoduls ein Schwimmpotential besitzen.

4. Steuereinheit nach Anspruch 3, **dadurch gekennzeichnet, dass** die Stromversorgungseinrichtung des Schaltmoduls einerseits für jeden Ausgangspfad eine Dauerverbindung, vorzugsweise über einen Anpassungswiderstand (Rₚ), mit einer Speisespannung (Vcc) und andererseits eine Erdungseinrichtung (T1, T2, T3, T4) besitzt, die vom Mikrocontroller gesteuert wird.

5. Steuereinheit nach Anspruch 4, **dadurch gekennzeichnet, dass** jede Erdungseinrichtung einen Transistor (T1, T2, T3, T4) enthält, der im Schaltmodus so angeschlossen ist, dass ein digitales Ausgangssignal des Mikrocontrollers (19) es ermöglicht, das Massepotential zum Schaltmodul (7, 9, 13, 15) zu führen, um das lesen der Schaltzustände der Schalter der Module zu erlauben.

6. Schalteinheit nach einem der Ansprüche 1 bis 5, **dadurch gekennzeichnet, dass** jedes Schaltmodul mindestens eine Kennung (R_ID1, R_ID2) und ein Teilmodul (S_MOD1, S_MOD2, S_MOD3, S_MOD4, S_MOD5) mit mehreren Einzelschaltern (S1, S2, S3) enthält, die abhängig von den von einem Benutzer an das Teilmodul angewendeten Steuerstellungen offene oder geschlossene Schaltzustände annehmen können.

7. Einheit nach Anspruch 6, **dadurch gekennzeichnet, dass** ein Teilmodul in Form einer Drucktaste, eines Kippschalters, eines indexierten Rädchens, eines Drehrings oder eines Steuerhebels hergestellt wird.

8. Schalteinheit nach Anspruch 6 oder 7, **dadurch gekennzeichnet, dass** die Kennung durch mindestens ein für dieses Schaltmodul spezifisches elektrisches Bauteil realisiert wird, insbesondere einen spezifischen Widerstand (R_ID1, R_ID2).

9. Schalteinheit nach Anspruch 8 in Kombination mit Anspruch 4 oder 5, **dadurch gekennzeichnet, dass** das spezifische elektrische Bauteil (R_ID1, R_ID2) einerseits an einen Ausgangspfad des Schaltmoduls (ID1; ID2) und andererseits an die Erdungseinrichtungen (T1; T2; T3; T4) angeschlossen ist, die vom Mikrocontroller (19) gesteuert werden.

10. Schalteinheit nach einem der Ansprüche 6 bis 9, **dadurch gekennzeichnet, dass** in einem Schaltmodul (7, 9, 13, 15) das mindestens eine Teilmodul (S_MOD1) und der mindestens eine Kennungspfad, der das spezifische Bauteil (R_ID1, R_ID2) des Moduls aufweist, an einem Ende über eine gemeinsame Leitung mit den Aktivierungseinrichtungen des Lesens eines Schaltzustands verbunden sind.

11. Schalteinheit nach einem der Ansprüche 6 bis 10, **dadurch gekennzeichnet, dass** mindestens ein Teilschaltmodul (S_MOD1) eine elektrische Schaltung mit zwei parallelgeschalteten Zweigen (B1, B2) aufweist, von denen der erste Zweig (B1) in Reihe einen ersten Schalter (S1) und einen ersten Widerstand (R1) aufweist, und von denen der zweite Zweig (B2) in Reihe einen zweiten Widerstand (R2) und einen zweiten Schalter (S2) aufweist, wobei die zwei Zweige (B1, B2) in der Mitte zwischen dem ersten Schalter (S1) und dem ersten Widerstand (R1) einerseits bzw. dem zweiten Widerstand (R2) und dem zweiten Schalter (S2) andererseits über einen dritten Schalter (S3) verbunden sein können, um fünf Spannungspegel erhalten zu können, die fünf unterschiedliche Schaltzustände der Einheit aus erstem, zweitem und drittem Schalter (S1, S2, S3) darstellen.

12. Schalteinheit nach Anspruch 11, **dadurch gekennzeichnet, dass** der erste (R1) und der zweite Widerstand (R2) gleich sind.

13. Schalteinheit nach Anspruch 12, **dadurch gekennzeichnet, dass** der Wert des ersten und des zweiten Widerstands zwischen 2kΩ und 5kΩ, vorzugsweise in der Größenordnung von 3,6kΩ gewählt wird.

14. Schalteinheit nach einem der Ansprüche 1 bis 13, **dadurch gekennzeichnet, dass** der Mikrocontroller (19) so konfiguriert ist, dass er im Bereich jedes Platzes das Lesen der Schaltzustände periodisch aktiviert.

15. Schalteinheit nach einem der Ansprüche 1 bis 14, **dadurch gekennzeichnet, dass** der Mikrocontroller (19) so konfiguriert ist, dass er seine Ausgangssignale in einem Kommunikationsnetz, insbesondere einem Netzbus des Typs LIN oder CAN, liefert.

16. Schalteinheit nach einem der Ansprüche 1 bis 15, **dadurch** gekenntzeichnet, dass die Mutterplatine (17) Anschlussplätze (E1, E2, E3, E4) auf gegenüberliegenden Seiten besitzt, und dass die Verteilung der äquivalenten Pfade (L1, L2, L3, L4, L5, ID1, ID2) umgekehrt wird, um den Anschluss der Schaltmodule unabgängig von der gewählten Seite des Platzes zu erlauben.
